# EUROPEAN PATENT APPLICATION

(11) **EP 1 455 457 A1**
(43) Date of publication of application: **08.09.2004**
(21) Application number: 02251283.4
(22) Date of filing: 25.02.2002
(51) Int. Cl.: H03M 13/29

(54) **Simple early stopping criterion for maximum likelihood soft output decoding algorithms**

(71) Applicant: Agilent Technologies, Inc. (a Delaware corporation), Palo Alto, CA 94303 (US)
(72) Inventor: Hendrix, Zeger Agilent Techn. Belgium S.A./N.V, Rotselaar, AN 3110 (BE)
(74) Representative: Coker, David Graeme

(57) **Abstract**

The present invention is related to a method for reducing power consumption of a decoder to decode a digital signal using a maximum likelihood soft output algorithm, comprising the steps of:
- Submitting each received bit of said digital signal for processing to said decoder,
- Calculating a likelihood value of each received bit of said digital signal,
characterised in that said method further comprises:
- Fixing a threshold value which is a positive integer lying between zero and the maximum likelihood value,
- Comparing the magnitude of said likelihood values to said threshold value
- Repeating the steps of submitting, calculating and comparing until said likelihood values are at least equal to said threshold value, and
- Providing the decoded digital signal at an output terminal..

## Description

### Field of the invention

The present invention is generally related to error handling in the field of communication systems, and more particularly to a new early stopping criterion for maximum likelihood soft output decoding algorithms.

### State of the art

In wireless digital systems such as UMTS systems, data is rarely received errorless, due to atmospheric and other interference. Therefore, various error correction means have been developed and deployed to handle information received One of these error correction systems comprises transmitter-side encoding (e.g. convolutional encoding) followed by receiver-side decoding, which should be able to eliminate all errors introduced by the transfer of the data from transmitter to receiver over a transmission channel. Receiver-side decoding can, among others, be performed by maximum likelihood soft output decoding algorithms, such as Maximum A Posteriori (MAP), and its variants Log-MAP and Max-Log-MAP.

Error correction in these algorithms usually requires more iterations as more errors occur. Therefore, usually a sufficient amount of iterations is fixed so as to obtain reasonable quality of signal, even when reception is bad, which means that the decoder is configured for worst-case reception all the time. However, this means that when signal quality is good, the decoder will use too many iterations, leading to higher power consumption than strictly necessary. Therefore, early stopping criteria were devised for such maximum likelihood soft output decoding algorithms. Such an early stopping criterion allows the decoder to determine the number of iterations needed to obtain acceptable error rates.

Several early stopping criteria have been proposed and used for the Log-MAP and Max-Log-MAP algorithms:
- **CRC:** A Cyclic Redundancy Check is added to the data before it is sent over the channel. Decoding stops when the CRC detects no errors.
- **Cross Entropy (CE):** Calculates the cross entropy between the results (Log Likelihood Ratio (LLR) values) of the current half iteration and the results of the previous half iteration, and makes a decision based on this cross entropy. If the cross entropy is small enough, decoding is stopped.
- **Sign Change Ratio (SCR):** Counts the number of sign changes between the results (LLR-values) of the current half iteration and the results of the previous half iteration, and makes a decision based on this count. If the number of sign changes is smaller than q x N, decoding is stopped (where N is the length of the block to be decoded, and q is typically in the range from 0.005 to 0.05).
- **Sign Difference Ratio (SDR):** Counts the number of sign changes between the a priori input of a half iteration and the extrinsic information output of that half iteration, and makes a decision based on this count. If the number of sign changes is smaller than q x N, decoding is stopped (where N is the length of the block to be decoded, and q is typically in the range from 0.001 to 0.01).

Although performance of these early stopping criteria is quite good, they do present some important disadvantages:
- **CRC** requires extra computations and the CRC has to be sent along with the data (which compromises bandwidth efficiency).
- **CE** requires extra computations and the results of the previous iteration have to be stored in extra memory.
   Extra read and write actions are required.
- **SCR** requires extra memory to store the results from the previous iteration. Computational complexity can be ignored. Extra read and write actions are required.
- **SDR** requires no extra memory and computational complexity can be ignored. Reading of the a priori input however (for comparison with the extrinsic information output), requires one memory-read per bit and per iteration.

### Aims of the invention

The present invention aims to provide a novel early stopping criterion for maximum likelihood soft output decoding algorithms, which does not require excessive extra computation and which is cheap to implement. It is further object of the present invention to provide a method of decoding a digital signal which reduces the power consumption of the decoder.

### Summary of the invention

The present invention concerns a method of decoding a digital signal using a maximum likelihood soft output algorithm, comprising the steps of:
- Submitting each received bit of said digital signal for processing to said decoder,
- Calculating a likelihood value of each received bit of said digital signal,
characterised in that said method further comprises:
- Fixing a threshold value which is a positive integer lying between zero and the maximum likelihood value,
- Comparing the magnitude of said likelihood values to said threshold value
- Repeating the steps of submitting, calculating and comparing until said likelihood values are at least equal to said threshold value, and
- Providing the decoded digital signal at an output terminal.

In a preferred embodiment of the invention, the likelihood value is a Log Likelihood Ratio value.

The method according to the invention further preferably comprises the steps of setting a maximum number of iterations, and the decoded signal is in such case provided at an output signal when the likelihood values are at least equal to said threshold value or when the number of times the steps of submitting, calculating and comparing are performed is equal to said maximum number of iterations.

The digital signal can be a signal selected from the group consisting of IMT-2000, UMTS, W-CDMA an CDMA-2000 signals.

Another embodiment of the invention concerns a decoding apparatus arranged to execute the method of the present invention as disclosed above.

The decoding apparatus according to the present invention can be characterised in that the threshold and/or the maximum number of iterations can be adapted to a desired quality of decoding. Said quality of decoding can be determined by the type of data to be decoded.

Another embodiment of the present invention concerns an apparatus for receiving encoded data via a wireless connection from a transmitting apparatus, comprising a decoding apparatus according to the present invention such as disclosed higher.

Yet another embodiment of the present invention concerns a computer program comprising program code means for performing all the steps of the method of the present invention as described higher when said program is run on a computer or a processor.

### Short description of the drawings

Figure 1 represents the simplified data flow of a Log-MAP decoder.

Figures 2, 3 and 4 respectively show the power consumption, performance, and a combination of both compared to the threshold magnitude.

Figure 5 represents the simplified data flow of the Log-MAP decoder with the proposed early stopping criterion.

Figures 6 and 7 represent the Bit Error Rate in relation to the Eb/No respectively without and with early stopping criterion.

### Detailed description of the invention

The early-stopping criterion presented here, is applicable to all iterative decoding systems that are based on Maximum Likelihood soft output decoding algorithms which calculate for each received bit the most probable information bit to have been transmitted, given the coded sequence.

The Maximum A Posteriori (MAP) algorithm and its derivatives are such algorithms. The Soft Output Viterbi Algorithm (SOVA) on the other hand is not such an algorithm, since it calculates the most probable information *sequence* to have been transmitted, given the coded sequence.

Through this criterion, it is possible to significantly reduce the power consumption of the used decoding algorithm, with almost no degradation in decoding performance.

The criterion according to the present invention is based on threshold detection. By changing the threshold, any desired trade-off between power consumption and performance (within the limits of the decoding algorithm) can be realised. Implementation of this criterion requires almost no additional hardware.

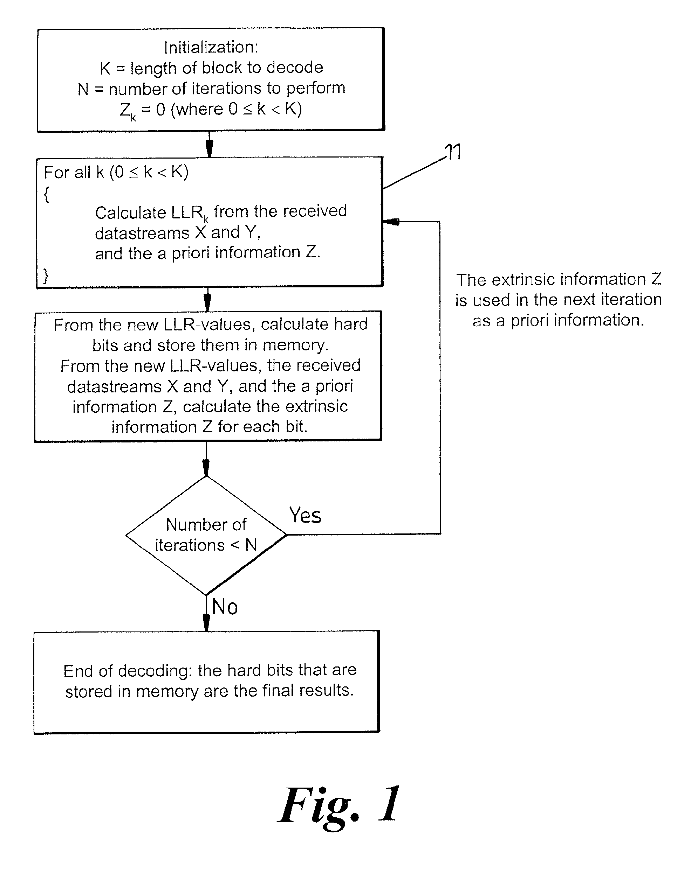

The Log-MAP algorithm (which is a derivative of the MAP algorithm by taking its logarithm) will be discussed as an example of the applicable decoding algorithms (See figure 1).

The Log-MAP algorithm is a Soft Input Soft Output (SISO) algorithm. Soft output decision algorithms provide as an output a number, which is a measure of the reliability of the decoder's hard decision. Such number, on which basis a decision regarding the value of a particular bit is made, is referred to as a likelihood value for the purpose of this application. For the Log-MAP algorithm, these soft outputs are Log Likelihood Ratio (LLR) values (one value for each bit to be decoded) . LLR values can be either positive or negative, and have a limited absolute value. The sign of the value corresponds to the decoder's hard decision, while the magnitude is a measure of the reliability of that decision.

When the LLR values for each bit have been calculated, one iteration has been performed. Several iterations can be performed, each time using the LLR values of the previous iteration as inputs (together with the original input data). After each iteration, soft outputs can be converted to hard bits by taking the sign-bits of the LLR values.

### Example 1:

There are a number of early stopping techniques which can be applied to the discussed decoding algorithms. The goal of these techniques is to make the decoder able to decide when decoding can be stopped, based on the quality of the results after each iteration.

When no such criterion is applied, the quality of the results is not evaluated, and the decoder will perform a fixed number of iterations.

Suppose that the number of iterations is fixed and set to 10, and that 3 blocks of data have to be decoded. The decoder will now perform 10 iterations on each block, hence 30 iterations in total. For each block, one could write out the number of errors left in that block after each iteration. Put in a table, one could obtain the following:

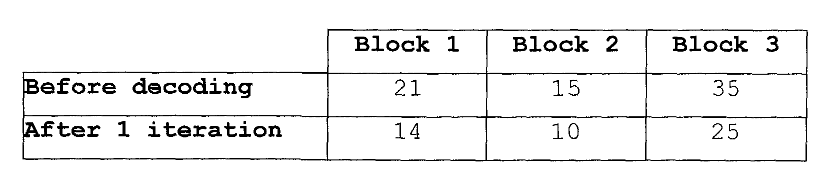

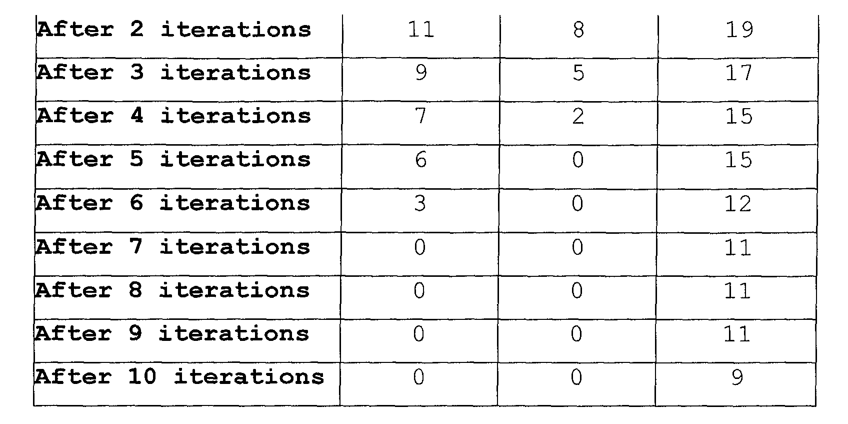

As can be seen from the table, after 10 iterations there are no errors left in blocks 1 and 2, and 9 errors in block 3. A total of 30 iterations has been performed.

As can also be seen, the same results could have been achieved by performing 6 iterations on block 1, 5 iterations on block 2 and 10 iterations on block 3. This is a total of 21 iterations. In this case, the decoding algorithm would thus have consumed 30% less power without any loss in performance.

**The criterion according to the present invention** (Minimum Likelihood Magnitude criterion, or MLM criterion): as mentioned earlier, LLR values can be either positive or negative, and have a limited absolute value. The sign of the value corresponds to the decoder's hard decision, while the magnitude is a measure of the reliability of that decision. When the algorithm is implemented in software or hardware, the magnitude of the LLR values will always be in a certain range (from 0 to X). When the LLR value of a certain bit has a magnitude of X, the decoder has made a 100% reliable decision. When the magnitude is close to 0, the decision is not reliable at all.

Suppose that one sets a threshold Y = X, and that decoding is only stopped when all LLR values have a magnitude that is at least equal to Y. Then we are forcing the decoder to perform iterations until it has found a 100% reliable decision for each bit.

However, when a noisy signal is received and has to be decoded, it is almost impossible for the decoder to make a 100% reliable decision for each bit. The result would be an infinite number of iterations for almost each block that has to be decoded. To prevent this, one has to set an upper limit N for the number of iterations.

Now one can give the threshold Y any value from 0 to X. When one sets Y = X, the decoder will almost always perform N iterations, which corresponds to the algorithm with a fixed number of iterations and without any early stopping criterion.
When one sets Y = 0, the decoder will only perform 1 iteration, since all LLR values will have at least a magnitude of 0 after 1 iteration.

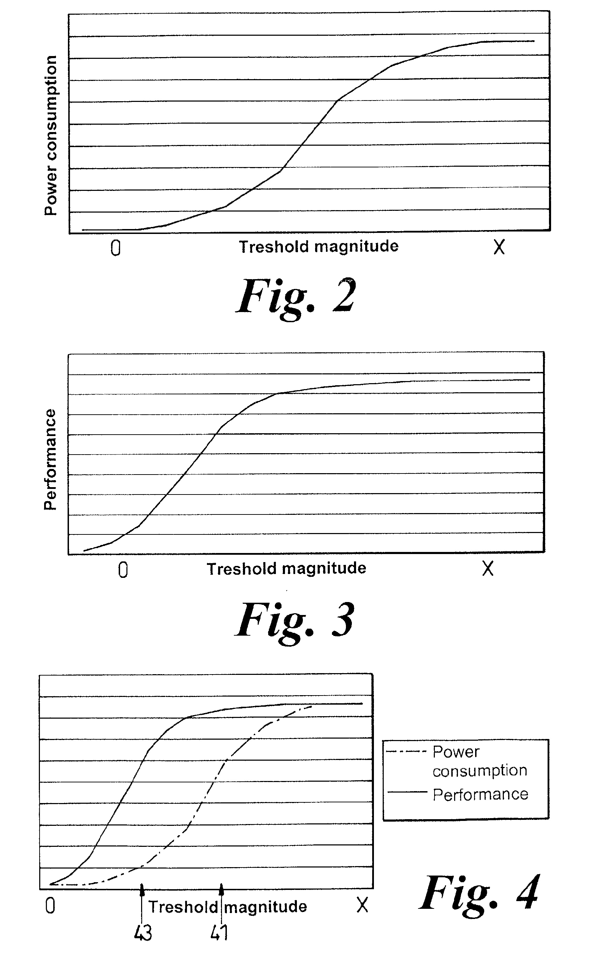

The power consumption of the decoder can be linked to the magnitude of the threshold as shown in figure 2 (approximation).

The performance of the decoder (number of errors repaired) can be linked to the magnitude of the threshold as shown in figure 3 (approximation).

A good trade-off between performance (number of errors repaired) and power consumption (number of iterations) can easily be chosen: start by setting the threshold magnitude equal to the maximum LLR magnitude X, and run performance tests. Lower the threshold and run performance tests until performance starts to deteriorate. As can be seen on figure 4, the threshold can be lowered quite a bit before performance starts to deteriorate noticeably (41). At that point, power consumption has already decreased significantly. Power consumption can thus be decreased significantly with almost no decrease in performance.

When further lowering the threshold magnitude, performance starts decreasing while the power consumption also keeps decreasing (43). In this region, a trade-off can be made depending on the required performance. Power consumption can be further decreased, depending on the required performance.

The proposed criterion performs equally well as the SDR criterion, which in its turn performs better than the CE criterion and the SCR criterion. The difference between the SDR criterion and the proposed criterion, is that the implementation of the criterion itself consumes less power to achieve the same results.

As said before, execution of the SDR criterion requires one memory-read per bit and per iteration. The SDR criterion also requires a counter of size N, the multiplication of 2 variable signals (q and N, where 0.001 < q < 0.01), and comparison of the counter and the product.

The proposed criterion only requires comparison of the magnitude of each LLR value to the threshold.

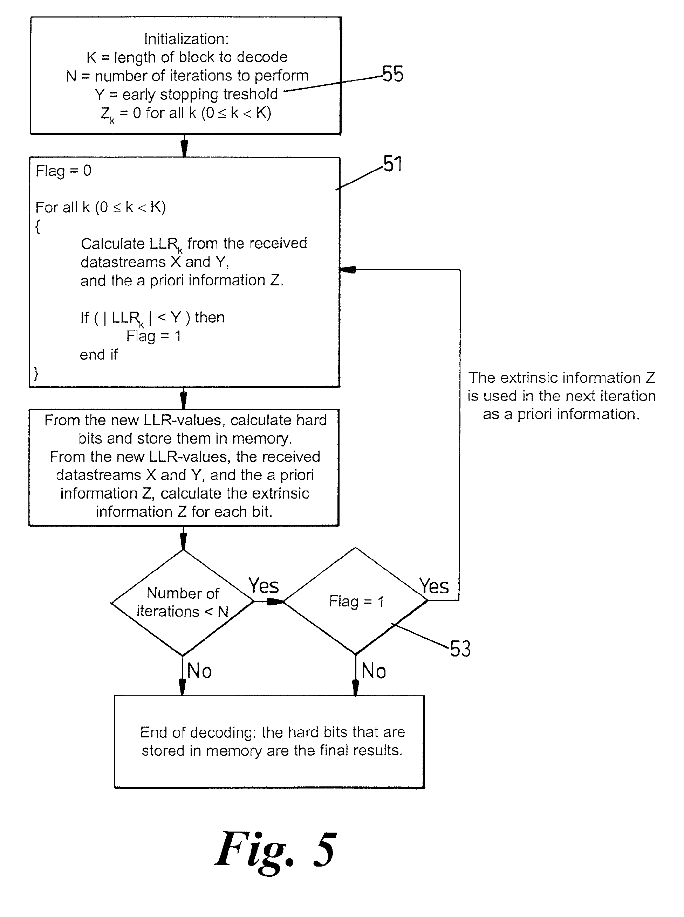

Figure 5 represents the simplified data flow of the Log-MAP decoder with the proposed early stopping criterion. Compared to the normal decoder as depicted in figure 1, the main difference lies in the calculation block 51 (compared to calculation block 11 of figure 1). Not only are the LLR values calculated (as in the prior art algorithm), but the calculated LLR values are also compared to a threshold Y (55), setting a flag indicating whether the magnitude of one of the LLR values is lower than said threshold Y. Said flag servers as an additional decision parameter to stop or continue iteration (53).

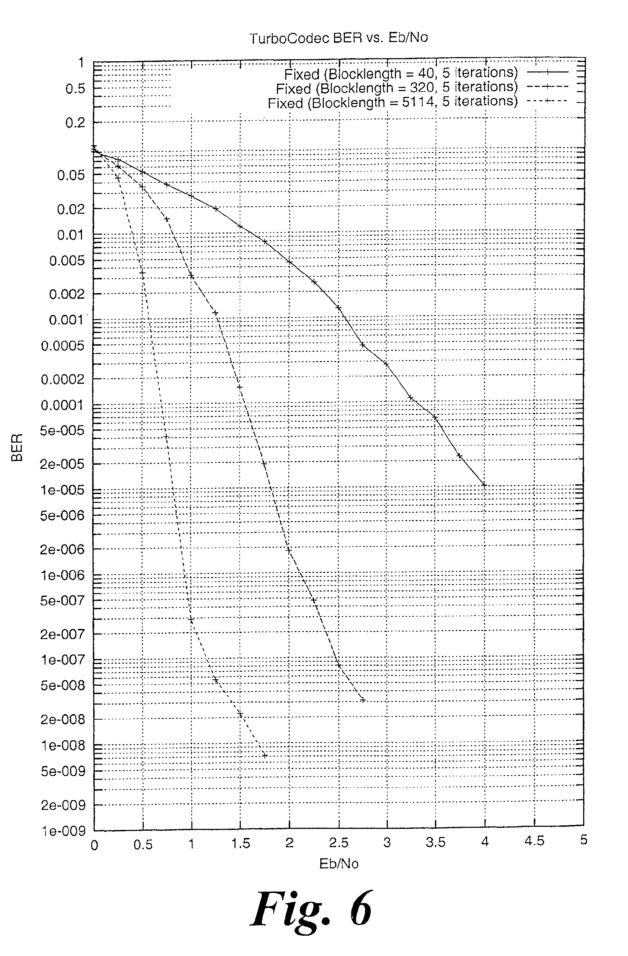

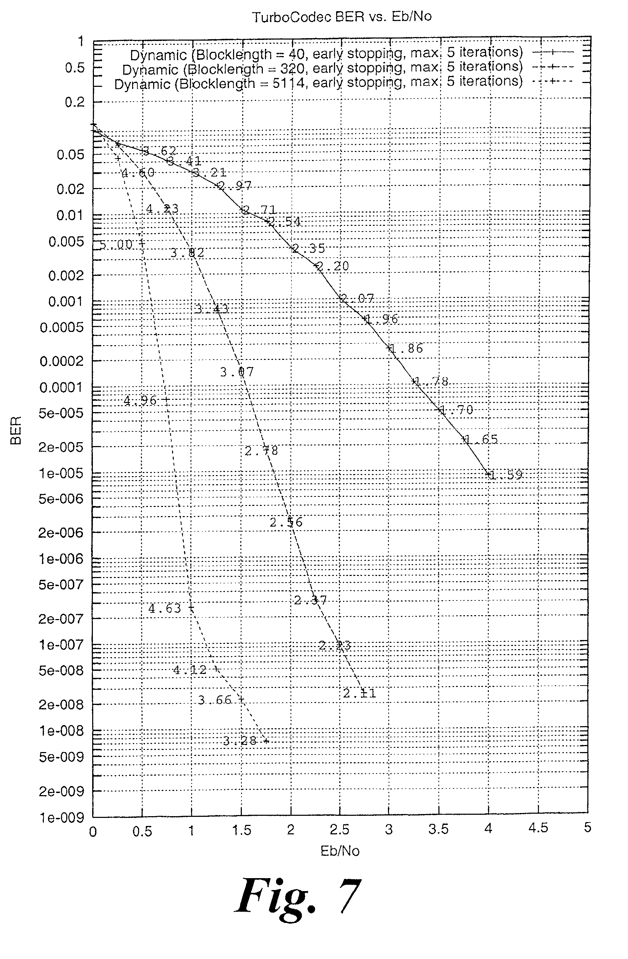

Figures 6 and 7 give an example of the reduced power consumption when applying the MLM criterion in a Max-Log-MAP turbo decoder. Figure 6 represents the BER (Bit Error Rate) curves when using a fixed number of 5 iterations. Figure 7 represents the BER (Bit Error Rate) curves when using the MLM criterion and a maximum number of 5 iterations. Eb/N₀ represent the signal to noise ratio (in dB). The threshold was set to a value half the size of the maximum LLR magnitude. The actual (average) number of iterations performed for each data point is indicated next to each data point. As can be seen, the system which uses the MLM criterion performs significantly less iterations to achieve the same BER under the same conditions as the system with a fixed number of iterations.

More particularly, the graphs represented in figures 6 and 7 correlate well to each other, meaning that the decoding performance of the decoder when using a dynamic number of iterations according to the invention is very comparable to the classic fixed number of iterations. This can be illustrated by e.g. taking the rightmost point of the graphs for a blocklength of 40. In both figures, this point lies at a signal/noise ration of 4dB and a BER of about 1e-5. This means that for a block length of 40 and a signal to noise ratio of 4dB, about 1 on 100.000 bits will still contain an error. Both algorithms perform thus equally well, but the algorithm of the invention only needs 1.59 iterations (on average) to achieve this performance, while the state of the art algorithm always iterates 5 times.

An important embodiment of the present invention concerns an apparatus for receiving encoded data over a wireless connection. Such an apparatus will comprise a decoder to decode the encoded data, hence such an apparatus comprising a decoder adapted to execute the method of the invention is comprised in the present invention.

In a preferred embodiment, said apparatus is a multi-purpose apparatus, e.g. an apparatus which can receive, decode and use a plurality of data types. Data types which can be sent over a wireless connection include voice, video, Internet information, GPS information, .... All data that can be digitally encoded can be sent over such a wireless connection.

However, not all data types need the same quality of transmission. E.g. typically video transmissions will require high quality, while other application will not be that sensitive to higher Bit Error Rates. Therefore, the decoder arranged to execute the method of the invention is preferably reprogrammable on-the-fly. The threshold in the method according to the invention and/or the maximal iteration number can be dynamic and can be changed according to the data type to be decoded.

## Claims

1. A method of decoding a digital signal using a maximum likelihood soft output algorithm, comprising the steps of:
• Submitting each received bit of said digital signal for processing to said decoder,
• Calculating a likelihood value of each received bit of said digital signal,
**characterised in that** said method further comprises:
• Fixing a threshold value which is a positive integer lying between zero and the maximum likelihood value,
• Comparing the magnitude of said likelihood values to said threshold value
• Repeating the steps of submitting, calculating and comparing until said likelihood values are at least equal to said threshold value, and
• Providing the decoded digital signal at an output terminal.

2. The method as in claim 1, **characterised in that** the likelihood value is a Log Likelihood Ratio value.

3. The method of claim 1 or 2, **characterised in that** the method further comprises the steps of setting a maximum number of iterations, and wherein the decoded signal is provided at an output signal when the likelihood values are at least equal to said threshold value or when the number of times the steps of submitting, calculating and comparing are performed is equal to said maximum number of iterations.

4. The method of any of the claims 1 to 3, **characterised in that** said digital signal is a signal selected from the group consisting of IMT-2000, UMTS, W-CDMA an CDMA-2000 signals.

5. A decoding apparatus arranged to execute the method of claim 1.

6. The decoding apparatus as in claim 5, **characterised in that** the threshold and/or the maximum number of iterations can be adapted to a desired quality of decoding.

7. The decoding apparatus as in claim 6, wherein said quality of decoding is determined by the type of data to be decoded.

8. An apparatus for receiving encoded data via a wireless connection from a transmitting apparatus, comprising a decoding apparatus such as in claim 5.

9. A computer program comprising program code means for performing all the steps of the method described in claim 1 when said program is run on a computer or a processor.
